## Europäisches Patentamt

## European Patent Office

## Office européen des brevets

(11) Publication number: **0 145 677 B1**

# EUROPEAN PATENT SPECIFICATION

(45) Date of publication of patent specification: **08.04.92** (51) Int. Cl.⁵: **H04N 7/087**

(21) Application number: **84830314.5**

(22) Date of filing: **20.11.84**

Divisional application 91104106.9 filed on
20/11/84.

(54) **Improved teletext receiver.**

(30) Priority: **22.11.83 IT 6822183**

(43) Date of publication of application:
**19.06.85 Bulletin 85/25**

(45) Publication of the grant of the patent:
**08.04.92 Bulletin 92/15**

(84) Designated Contracting States:
**DE FR GB NL SE**

(56) References cited:
**EP-A- 0 002 434**
**EP-A- 0 028 443**
**EP-A- 0 037 077**
**EP-A- 0 068 422**
**DE-A- 2 542 021**

**GRUNDIG-TECHNISCHE INFORMATIONEN,
vol. 27, no. 4/5, 1980, pages 171-196, FURTH,
(DE). P. HEIDER et al.: "Videotext und Bild-
schirmtext".**

**TOUTE L'ELECTRONIOUE, no. 435,
August/September 1978, pages 55-59, PARIS,
(FR). R. KARNATZKI: "Telecommande infra-
rouge pour TVC".**

(73) Proprietor: **Società Italiana per lo Sviluppo
dell'Elettronica S.I.SV.EL. S.p.A.
Via Castagnole, 59
I-10060 None (TO)(IT)**

(72) Inventor: **Belisomi, Pietro
Viale Rimembranza, 50
Pinerolo Torino(IT)**

EP 0 145 677 B1

## Description

The present invention refers to a television signal receiver, comprising a teletext type decoding circuit, capable of receiving, selecting, processing and reproducing a plurality of text pages, each one selectable by the user among all receivable pages, by sending to the decoding circuit, by means of control keys located on a relevant control device, in particular represented by a remote control device, a corresponding sequence of data specifying the selected page, said receiver comprising a data processor circuit, coupled to said decoding circuit, to said control device and to a memory device, said data processor circuit being provided for memorizing in said memory device the sequence of data specifying the selected page, and for modifying it in response to the depression of a special one of said control keys, so that the modified sequence specifies a defined different page other than the selected one.

It is known that in many European countries there are already operating or in an experimental phase transmission system (the so called Teletext or Televideo systems), which allow to transmit additional information, inserted in the standard video signal in the form of a digital coded signal, in a few normally free lines during the vertical retrace phase.

The said digital coded signal, at the user control, is decoded by a suitable decoding circuit, which is known in se, and may be inserted as an additional board in a normal television receiver, so allowing to display information pages, with text or graphics.

The number of the pages available to the user is of a few hundreds, grouped by matter (e.g. last news pag. 110-125, sports pag. 150-162, politics pag. 210-222, games pag. 315-345, etc); in the first page normally there is a directory, by matter, with the corresponding page numbers.

Using the known decoders, the user is compelled, each time he or she want to see a selected page, to press consecutively three numeric keys so to build the three figures number of the desired page; moreover, each time he or she wants to see the next page (because the wanted information occupies a few consecutive pages) he or she is compelled to build a new three figures number, if not even to recall the directory page, having in the mean time forgotten the desired page number.

Therefore many remote control keypresses are necessary, so reducing also the life of the remote control batteries; moreover all these manoevres are uneasy, and also it may so happen that the remote control receiver does not receive correctly a command (e.g. if the transmitter was inadvertently misaligned) and in this case, if the user does not notice the error, the received number sequence being incorrect, it must be repeated completely from the beginning.

It is known from EP-A-0 037 077 a method for reducing the waiting time for selecting text pages and graphics, which are transferred in an information system by a transmitter to a receiver, through a data channel by adding another information. In the receiver, besides the pages to be displayed, also the adjacent pages are memorized. By means of this receiver it is possible to comunicate with a control panel.

This method is fast in searching the page in rhe information system, but it requires the addition of another information for selecting pages and their arguments. The addition of another information is a serious restriction which limits the use of this method.

Also known from the article: Grundig Technische Informationen, vol. 27, no. 4/5, 1980, pages 171-196, Fürth, P. Heider et al. "Videotext und Bildschirmtext", is a television signal receiver, comprising a teletext type decoding circuit capable of selecting, processing and reproducing a plurality of text pages, each one selectable by the user sending to the decoding circuit, by means of control keys, located on a remote control device, a sequence of data specifying the selected page; the receiver comprises a data processor circuit, coupled to said control device, provided for memorizing in an internal register the said sequence of data; a special one of said control keys is provided, which allows the user to modify the memorized sequence, in order to specify a predetermined page, other than the selected one (page 100).

The object of the present invention is therefore to indicate a receiver including a teletext signal decoder not having the described disadvantages.

The present invention refers therefore to a television signal receiver, comprising a teletext type decoding circuit, capable of receiving, selecting, processing and reproducing a plurality of text pages, each one selectable by the user among all receivable pages, by sending to the decoding circuit, by means of control keys located on a relevant control device, in particular represented by a remote control device, a corresponding sequence of data specifying the selected page, said receiver comprising a data processor circuit, coupled to said decoding circuit, to said control device and to a memory device, said data processor circuit being provided for memorizing in said memory device the sequence of data specifying the selected page, and for modifying it in response to the depression of a special one of said control keys, so that the modified sequence specifies a defined different page other than the selected one, characterized in that the said special key is respectively an increment or decrement key and that said data processor circuit, as a consequence of the depressing of said special key, recalls said memorized sequence from said memory device and respectively increments or decrements it, then memorizes it again and sends it to said decoding circuit.

The invention is described in the following, in order to clarify it, in particular with reference to the attached drawings, which are given only as an informative and not limiting example.

Figure 1 represents a part of the block-diagram of a television receiver comprising a teletext decoder of known type.

Figure 2 represents the block-diagram of the same part of a television receiver comprising an improved teletext decoder according to the present invention.

Figure 3 represents the block-diagram of the basic functions performed by the circuits included in the decoder according to the invention.

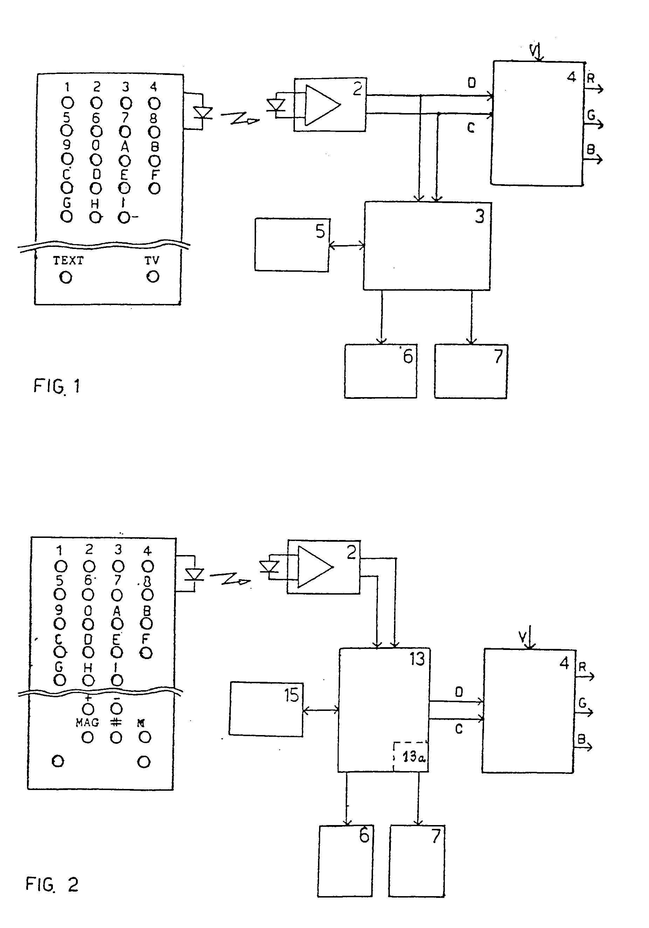

In the figure 1 the number 1 indicates an infrared remote control transmitter, comprising a keyboard and known coding and transmitting circuits (e.g. the integrated circuit SAB 3021 of the firm Philips); the number 2 indicates an infrared receiving circuit comprising an amplifier and a decoder (e.g. integrated circuit SAB 3042 of the firm Philips); the outputs D (data output) and C (clock output) are coupled to a known control unit 3, which controls the tuning and the analogic controls of the television receiver (e.g. comprising the integrated circuits SAB 1018, SAB 3034 and the microprocessor 8048 of the firm Philips), and to a teletext signals decoder circuit 4, of known type (including for instance the integrated circuits SAB 5020, SAB 5030, SAB 5040 and SAB 5050 of the firm Philips).

The remote control transmitter comprises:
- a first group of 10 keys with the number from 0 to 9;
- a second group of 9 keys with the letters from A to I;
- two keys with the labels "TEXT" and "TV";
- other additional keys, normally present in remote control transmitters and not shown in the drawing.

The tuning control unit 3 is coupled to:
- a random access memory circuit 5 to memorize and recall the tuning data for the preferred broadcasting stations to be selected;
- a circuit 6 to amplify and filter the tuning voltage for the tuning unit itself (which is not represented in the figure);
- a circuit 7 to amplify and filter the control voltages for the circuits which controls the analogic commands (brightness, volume, contrast etc.) also not represented in the figure.

The teletext signals decoder circuit 4 receives also an input signal "V" from the video detector of the set, not shown in the figure, and supplies at three output terminals the color signals R,G,B to be applied to the final video amplifiers of the set.

As regards the above cited integrated circuits and the relevant associated circuits reference is made, for a more detailed description, to the catalogs and the application notes of the manufacturer.

The operation of the circuit represented in figure 1 is as follows: When the "TV" key is depressed, the decoder 2 transmits to the microprocessor operated control unit 3 an enabling command which enables the normal TV receiving operation; pressing consecutively the numbered keys or any one of the additional keys (not shown in the figure), the control unit performs the tuning operation on a different station, provided that station has been already memorized in the memory 5 by means of the circuit 6, or the regulation of the desired analog command by means of circuit 7.

Depressing the "TEXT" key the receiver 2 sends to the decoder 4 an enabling command which enables the operation as a teletext receiver; pressing consecutively three numbered keys, corresponding to the three figures number of the desired teletext page, the teletext decoder selects the choosed page among all the transmitted pages, memorize all the lines of the said page and sends to the R,G,B outputs the suitable signals to display on the picture tube of the set the desired page.

On the contrary, pressing one of the letter keys, the user may select some known options relating to the way how to visualize the pages (A = small, i.e. normal size of characters, B = large, i.e. double character height, C = clear, i.e. clear the teletext page, E = mixed, teletext page superimposed to the normal video picture, etc.).

Eventually, pressing the "TV" key the normal television reception is reestablished.

In figure 2 the numbers 2,4,6 and 7 indicate blocks which correspond both as construction and as operation to the blocks indicated in figure 1 by the same numbers; they therefore are not described again for sake of conciseness.

The numbers 11,13 and 15 indicate in order control means, processing means and memory circuit which are the like of the circuits indicated in figure 1 by the numbers 1,3 and 5, modified according to the present invention.

The control means comprises, besides the keys already described referring to fig. 1, another group of 5 keys which are labeled respectively "+","-","MAG"," ","M".

The circuit which is the infrared remote control receiver, indicated by the number 2, is only connected to the processing means 13, which supplies two data and clock outputs "D" and "C" to the teletext decoder.

The processing means 13 is so constructed to perform, besides the functions of the tuning control unit 3, also other functions relating to the teletext operation, according to the present invention. The memory means 15 , like the circuit 5, is connected to the processing means 13, but is different having a greater number of cells.

The operation of the circuit represented in fig. 2 is the following: Depressing the " " key after the "TEXT" key has been depressed, a operation condition is selected which may be called of "direct" request and the processing means 13 is enabled to perform the same functions as per the circuit of fig. 1 when the "TEXT" key is depressed.

In fact, depressing consecutively the numbered keys or the keys labeled by the letters from "A" to "I", unit 13 supplies to the teletext decoder the same data and clock signals "D" and "C" as received by the remote processing means 2, so that the teletext decoder can respectively select a page indicated by three figures or perform the display operations; in the mean time processing means 13 memorizes in a internal register 13a the number of the selected page.

If, on the contrary, after the "direct" request condition has been selected, the key " + " or the key "-" is depressed, processing means 13 reads in the internal register the number of the last selected page, increments or decrements respectively said page number in the register 13a by one unit and sends to the teletext decoder the new page number.

In this way it is very fast and easy for the user to display consecutively a few information pages, starting from one of them.

If, on the contrary, after the "direct" request condition has been selected, the "M" key is depressed, processing means 13 is made ready to store in the memory means 15 the three figures of the pesently selected page contained in the said internal register.

After that, when one of the ten numbered keys is depressed, processing means 13 stores the said three figures in a selected group of three memory cells, corresponding to said key-number.

In this way it is possible to memorize ten preferred pages each one related to one of the ten numbered keys.

If the "MAC" key is depressed the direct request condition has been left and the control unit is enabled to a selection condition which may be called of "indirect" request, that is a selection made recalling the page number from the memory, and not directly inputting it by the keyboard.

In this operating condition, to recall any one of the ten previously memorized pages, it is sufficient to press only one key, that is the corresponding one among the ten numbered keys: the processing means 13 then reads from the memory means, in the cells corresponding to the inputted address, the relevant memorized page number, and sends the three figures to the teletext decoder.

In this way, considering that normally the page numbers, corresponding to the different types of information, remain unchanged as long as possible in order to aid the selection by the user, it is possible to store the page numbers corresponding to the most interesting information and recall them very easily depressing only one key.

Moreover in the indirect request condition, according to a first preferred embodiment, depressing the " + " or "-" key, the processing means recalls from memory means 15 the figures which correspond to the preceding or successive cells and send them to the teletext decoder. In this way it is possible in an easy way to request sequentially all the preferred pages previously memorized.

In a second preferred embodiment, depressing the " + " or "-" key, in the indirect request condition too, the processing means 13 reads in the internal register the number of the last selected page, increments or decrements respectively said page number in the internal register by one unit and sends to the teletext decoder the new page number.

In this way the user can in the indirect request condition depressing one key select the initial page of the group of pages pertaining to the preferred matter and then by means of the " + " key sequentially scan the following pages of said group.

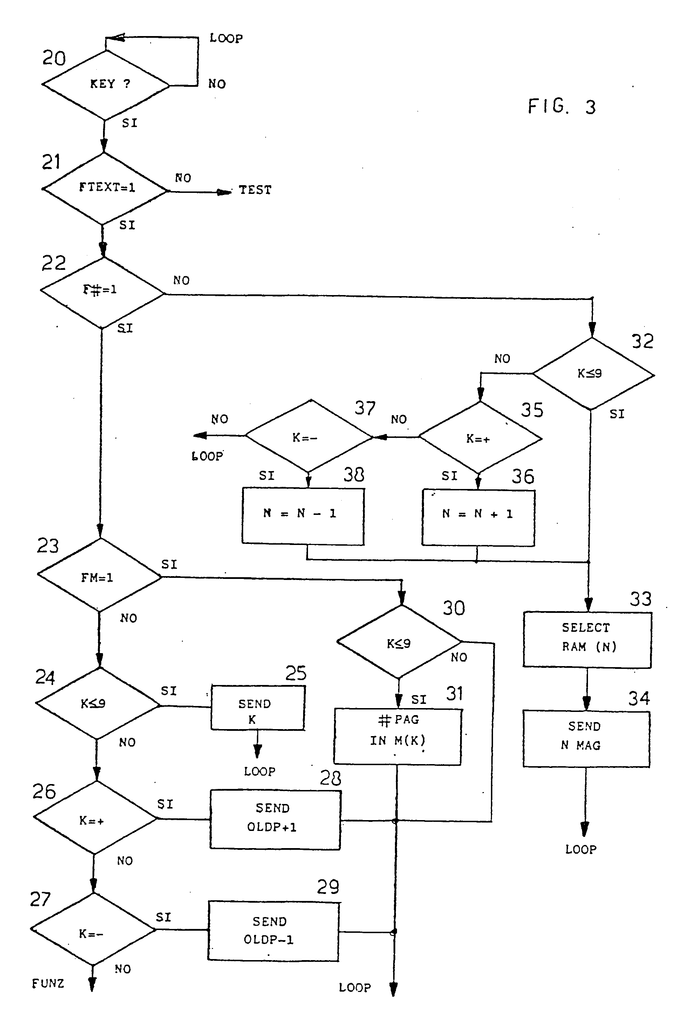

The operation of the microprocessor controlled processing means 13 may be better understood examining the elemental function block diagram represented in figure 3, referring particularly to the the sequential and indirect request of pages.

In figure 3 the signal "LOOP" activates a block 20, which verifies if any key of the control means 11 has been depressed; The "NO" output generates the "LOOP" activation signal, the "SI" output activates a block 21 which verifies if the function "TEXT" has previously been selected.

The "NO" output of the block 21 supplies a "TEST" signal to enable the circuits, not described as completely known, which control the operation of the television receiver; the "SI" output supplies an enabling signal to the block 22, which verifies if the " = " function has previously been selected; the "SI" output (teletext operation in direct request condition) activates a block 23 which verifies if the "M" function has been previously selected; the "NO" output (direct request of a teletext page) activates a block 24 which verifies if the depressed key corresponds to a figure from 0 to 9; the "SI" output activates a block 25 which sends said figure to the teletext decoder and which supplies the "LOOP" activation signal; the "NO" output activates a block 26 and then a block 27 which verify if the depressed key corresponds to one of the symbols "+" or "-"; the "SI" outputs of blocks 26 and 27 activate respectively the blocks 28 and 29 which send to the teletext decoder three figures which correspond respectively to the last page number incremented or decremented by one unit and which then supply the "LOOP" activation signal; the "NO" outputs of blocks 26 and 27 supply a "FUNZ" signal which activates the execution, in a known way, of the functions relating to the way how to display the pages.

The "SI" output of block 23 (teletext memorizing function) activates a block 30 which verifies if the depressed key corresponds to a figure from 0 to 9; the "NO" output supplies the "LOOP" activation signal; the "SI" output activates a block 31 which performs the memorization of the three figures corresponding to the presently selected teletext page in suitable memory cells corresponding to the number of the depressed key.

The block 31 supplies then the "LOOP" activation signal.

The "NO" output of block 22 (activation of the indirect or "magazines" selection) activates a block 32 which verifies if the depressed key corresponds to a number "n" from 0 to 9; the "NO" output activates the block 35 and then the block 37 which together verify if the depressed key corresponds to the symbol "+" or to the symbol "-"; the "no" outputs produce the "LOOP" activation signal; the "SI" outputs activate respectively the blocks 36 and 38 which increment or decrement by one unit the number "n" which corresponds to the last selected group of memory cells; the "SI" output of block 32 and the blocks 36 and 38 activate then a block 33 which, according to the value of the number "n", selects a certain group of memory cells and a block 34 which reads in said cells the page number of three figures which they contain and sends the three figures to the teletext decoding unit.

From the description of figure 3 it is clear the way how to implement, according to the present invention, the functions of:
- up or down sequential request of teletext pages (blocks 24-29);
- memorization of a preferred page number (blocks 23,30,31);
- indirect request of a previously memorized page (blocks 32-34);
- sequential request of previously memorized pages (blocks 35-38).

From the description the present invention's advantages are clear. In fact the reading of the information contained in a sequence of teletext page is made very easy due to the possibility of up or down sequential request of the pages, which allows a fast and error free selection.

An additional advantage consists in the possibility to memorize the numbers of the most interesting pages which in this way may be recalled directly depressing only one key and without being compelled to recall and examine the general directory.

Many modifications of course are possible without departing from the scope of the present invention.

For instance it is possible to adopt integrated circuits other than the cited ones, which perform the same functions, to code, transmit and decode the teletext signals, to build the processing means 13, which may be also based on different microprocessors.

In the described example ten groups of memory cells have been used to memorize the numbers of ten preferred pages; it may be advisable, of course, to use a greater number of cells to memorize for instance 20 or 30 page numbers; it may also be appropriate to add to the control means 11 special keys to memorize the page numbers, labeled for instance: "last news", "sports", "politics", "economics" and so on.

Moreover instead of the control means 11 a cheaper keyboard may be used, directly connected to the processing means.

A further modification may consists in the addition of an automatic research circuit to sequentially scan the pages, starting from the present selected page, controlled by one or more dedicated keys (for instance one for the up search, one for the down search and one for the stop ) so that an automatic display of many consecutive pages may be obtained.

At least all that has been described may be easily and advantageously applied to receive on a home terminal the information transmitted on the telephonic network according to "PRESTEL" or "VIDEOTEL" or similar systems.

**Claims**

1. Television signal receiver, comprising a teletext type decoding circuit (4), capable of receiving, selecting, processing and reproducing a plurality of text pages, each one selectable by the user among all receivable pages, by sending to the decoding circuit (4), by means of control keys located on a relevant control device (11), in particular represented by a remote control device, a corresponding sequence of data specifying the selected page, said receiver comprising a data processor circuit (13), coupled to said decoding circuit (4), to said control device (11) and to a memory device (register 13a), said data processor circuit (13) being provided for memorizing in said memory device (register 13a) the sequence of data specifying the selected page, and for modifying it in response to the depression of a special one of said control keys, so that the modified sequence specifies a defined different page other than the selected one, characterized in that the said special key is respectively an increment ( + ) or decrement (-) key and that said data processor circuit (13), as a consequence of the depressing of said special key, recalls said memorized sequence from said memory device (register 13a) and respectively increments or decrements it, then memorizes it again and sends it to said decoding circuit (4).

2. Receiver according to claim 1, characterized in that there are provided further memory means (15) and that said data processor circuit (13) provides for performing, as a consequence of the depressing of a memory key (M) of said control device (11), the memorization in said further memory means (15) of said sequence of data corresponding to the page displayed at the moment when the said key (M) has been depressed, at an address determined by the user by the depression of one of the numbered (0..9) keys comprised in the control device (11) .

3. Receiver according to claim 2, characterized in that said data processor circuit (13) provide for recalling, as a consequence of the depressing of one of said numbered keys (0..9) comprised in the control device (11) of the memorized sequence of data, from said further memory means (15), taking it at the address specified by the recalling key, and sending said sequence of data to the decoding circuit (4) in order to allow the display of the desired page.

4. Receiver according to claim 3, characterized in that said data processor circuit (13), as a consequence of a control signal, produced depressing a condition choice key (MAG), comprised in said control device (11), enables said memory means (15) to be read in order to recall said sequence of data, corresponding to the preselected page, which the user wants to recall from said further memory means (15).

5. Receiver according to claim 4, characterized in that said data processor circuit (13) provides, as a consequence of the depression of a sequential search key ( + , -), comprised in said control device (11) for recalling from said further memory means (15), at the address immediately preceding or following the address corresponding to the sequence of data which specifying the presently displayed page, a new sequence of data to be sent to the decoding circuit (4) in order to allow for the display of the preceding or following page among the preselected pages.

**Revendications**

1. Récepteur de signaux de télévision, comprenant un circuit décodeur de type télétexte (4), permettant de recevoir, sélectionner, traiter et reproduire une pluralité de pages de texte, chacune pouvant être sélectionnée par l'utilisateur parmi l'ensemble des pages pouvant être reçues, par l'envoi au circuit décodeur (4),au moyen de touches de commande placées sur un dispositif de commande approprié(11)-,représenté en particulier par un dispositif de commande à distance ou télécommande, une série de données correspondante spécifiant la page sélectionnée, ledit récepteur comprenant un circuit de traitement de données (13), couplé audit circuit décodeur (4), audit dispositif de commande (11) et à un dispositif de mémoire (registre 13a), ledit circuit de traitement de données (13)étant prévu pour mémoriser dans ledit dispositif de mémoire (registre 13a) la série de données spécifiant la page sélectionnée, et pour la modifier en réponse à l'enfoncement d'une touche spéciale desdites touches de commande, de telle sorte que la série modifiée spécifie une page différente définie autre que la page sélectionnée, caractérisé en ce que ladite touche spéciale est respectivement une touche de progression ( + ) ou une touche de régression (-) et que ledit circuit de traitement de données (13), en conséquence de l'enfoncement de ladite touche spéciale, rappelle ladite série mémorisée dans ledit dispositif de mémoire (registre 13a) et la fait progresser ou la fait régresser respectivement, la remémorise ensuite et l'envoie audit circuit décodeur (4).

2. Récepteur selon la revendication 1, caractérisé en ce qu'un autre moyen à mémoire (15) est prévu et en ce que ledit circuit de traitement de données (13) assure l' exécution, en conséquence de l'enfoncement d'une touche de mémoire (M) dudit dispositif de commande(11),de la mémorisation dans ledit autre moyen à mémoire (15) de ladite série de données correspondant à la page visualisée au moment où ladite touche (M) a été enfoncée, à une adresse déterminée par l'utilisateur par l'enfoncement d'une des touches numérotées (0 ...9) comprises dans le dispositif de commande (11).

3. Récepteur selon la revendication 2, caractérisé en ce que ledit circuit de traitement de données 13) assure le rappel, en conséquence de l'enfoncement d'une desdites touches numérotées (0...9) comprises dans le dispositif de commande (11), de la série de données mémorisées dans ledit autre moyen a mémoire (15), en la prenant à l'adresse spécifiée par la touche de rappel, et l'envoi de ladite série de données au circuit décodeur (4) afin de permettre la visualisation de la page voulue.

4. Récepteur selon la revendication 3, caractérisé en ce que ledit circuit de traitement de données (13), en conséquence d'un signal de commande, produit en enfonçant une touche de choix d'état (MAG), comprise dans ledit dispositif de commande (11), valide ledit moyen à mémoire (15) pour sa lecture afin de rappeler ladite série de données, correspondant à la page présélectionnée, que l'utilisateur veut rappeler à partir dudit autre moyen à mémoire (15).

5. Récepteur selon la revendication 4, caractérisé en ce que ledit circuit de traitement de données (13) assure, en conséquence de l'enfoncement d'une touche de recherche séquentielle ( + ,-), comprise dans ledit dispositif de commande (11), le rappel à partir dudit autre moyen à mémoire (15), à l'adresse qui précède ou suit juste l'adresse correspondant à la série de données qui spécifie la page alors visualisée, d'une nouvelle série de données à envoyer au circuit décodeur (4) afin de permettre la visualisation de la page précédente ou suivante parmi les pages présélectionnées.

**Patentansprüche**

1. Fernsehsignalempfänger mit einer Teletext-Decodierschaltung (4) zum Empfang, zur Auswahl, Aufbereitung und Wiedergabe einer Vielzahl von Textseiten, von denen jede einzelne vom Benutzer aus allen empfangenen Seiten mittels Funktionstasten, die auf einer entsprechenden Bedienungseinrichtung (11), insbesondere einem Fernbedienungsgeber, angeordnet sind, durch Senden einer korrespondierenden Folge von Daten, die die ausgewählte Seite spezifizieren, an die Decodierschaltung (4) wählbar ist, welcher Empfänger eine Datenverarbeitungsschaltung (13) aufweist, die mit der Decodierschaltung (4), der Bedienungseinrichtung (11) und einer Speichereinrichtung (Register 13a) gekoppelt ist, welche Datenverarbeitungsschaltung (13) zum Speichern der Folge der Daten, zur Spezifizierung der gewählten Seite und zum Modifizieren derselben in Antwort auf die Betätigung einer speziellen Taste der Funktionstasten in der Speicherschaltung (Register 13a) vorgesehen ist, so daß die modifizierte Folge eine definierte andere Seite als die ausgewählte angibt, **dadurch gekennzeichnet**, daß die spezielle Taste eine entsprechende Inkrement ( + )- oder Dekrement (-)-Taste ist, und daß die Datenverarbeitungsschaltung (13) als Folge der Betätigung besagter spezieller Taste die gespeicherte Folge der Daten aus der Speichereinrichtung (13a) aufruft und entsprechend inkrementiert oder dekrementiert, sie dann wieder speichert und an die Decodierschaltung (4) ausgibt.

2. Empfänger nach Anspruch 1, dadurch gekennzeichnet, daß weitere Speichereinrichtungen (15) vorgesehen sind, und daß die Datenverarbeitungsschaltung (13) vorgesehen ist, um als Folge auf die Betätigung einer Speichertaste (M) der Bedienungseinrichtung (11) die Speicherung der Folge der Daten, die mit der Seite korrespondieren, die in dem Moment angezeigt wird, wenn die Taste (M) gedrückt worden ist, unter einer vom Benutzer bestimmten Adresse durch Betätigung einer der mit (0..9) numerierten auf der Fernbedienungseinrichtung (11) angeordneten Tasten in den weiteren Speichervorrichtungen durchzuführen.

3. Empfänger nach Anspruch 2, dadurch gekennzeichnet, daß die Datenverarbeitungsschaltung (13) dafür sorgt, daß als Folge der Betätigung einer der für die gespeicherte Folge von Daten vorgesehenen numerierten Tasten (0..9) der Bedienungseinrichtung (11) von den weiteren Speichereinrichtungen (15) die unter der von der Aufruftaste spezifizierten Adresse abgelegte Folge von Daten aufgerufen wird, und die Folge der Daten an die Decodierschaltung (4) sendet, um die Anzeige der gewünschten Seite zu ermöglichen.

4. Empfänger nach Anspruch 3, dadurch gekennzeichnet, daß die Datenverarbeitungsschaltung (13) als Folge eines Steuersignals, das durch Drücken einer Zustands-Wahltaste (MAG) auf der Bedienungseinrichtung (11) erzeugt wird, es den Speichereinrichtungen (15) ermöglicht, gelesen zu werden, um die Folge der Daten entsprechend der vorgewählten Seite aufzurufen, die der Benutzer aus den weiteren Speichereinrichtungen (15) aufzurufen wünscht.

**5.** Empfänger nach Anspruch 4, dadurch gekennzeichnet, daß die Datenverarbeitungsschaltung (13) als Folge des Druckes auf eine sequentielle Suchtaste ( + , -), die in der Bedienungseinrichtung (11) zum Aufrufen aus den weiteren Speichereinrichtungen (15) unter der Adresse, die unmittelbar der Adresse vorangeht oder der Adresse folgt, die der Folge von Daten zugeordnet ist, die die derzeit dargestellte Seite angibt, dafür sorgt, daß eine neue Folge von Daten an die Decodierschaltung (4) zu senden ist, um die vorangegangene oder folgende Seite unter den vorgewählten Seiten darstellen zu können.

FIG. 1

FIG. 2

FIG. 3